# EUROPEAN PATENT SPECIFICATION

(11) **EP 2 378 848 B1**
(45) Date of publication and mention of the grant of the patent: **27.05.2020**
(21) Application number: 11162122.3
(22) Date of filing: 12.04.2011
(51) Int. Cl.: H05K 7/02, H05K 7/20

(54) **Chassis with distributed jet cooling**
Chassis mit integrierter Strahlkühlung
Châssis avec refroidissement à jet distribué

(30) Priority: 14.04.2010 US 759899
(43) Date of publication of application: 19.10.2011
(73) Proprietor: GENERAL ELECTRIC COMPANY, Schenectady, NY 12345 (US)
(72) Inventor: Arik, Mehmet, Niskayuna NY 12309 (US); Gerstler, William Dwight, Niskayuna NY 12309 (US); Li, Ri, Niskayuna NY 12309 (US); Nicewarner, Earl Ross, Niskayuna NY 12309 (US); Schroeder, Christina Clyde, Niskayuna NY 12309 (US); Vander Ploeg, Benjamin Jon, Niskayuna NY 12309 (US); Whalen, Bryan Patrick, Niskayuna NY 12309 (US)
(74) Representative: Openshaw & Co.

(56) References cited:
- EP-A2- 2 116 730
- JP-A- H05 251 883
- US-A1- 2003 155 106
- US-A1- 2005 121 171
- US-A1- 2008 023 189
- US-A1- 2008 310 110
- US-A1- 2010 039 012
- Hilton Mello ET AL: "Numerical study of synthetic jet actuator effects in boundary layers", Journal of the Brazilian Society of Mechanical Sciences and Engineering, 1 March 2007 (2007-03-01), pages 34-41, XP055434541, DOI: 10.1590/S1678-58782007000100006 Retrieved from the Internet: URL:http://www.scielo.br/pdf/jbsmse/v29n1/ a06v29n1.pdf [retrieved on 2017-12-12]
- CHAUDHARI M ET AL: "Effect of orifice shape in synthetic jet based impingement cooling", EXPERIMENTAL THERMAL AND FLUID SCIENCE, ELSEVIER, AMSTERDAM, NL, vol. 34, no. 2, 1 February 2010 (2010-02-01), pages 246-256, XP026826202, ISSN: 0894-1777 [retrieved on 2009-11-13]
- RALPH REMSBURG ET AL: "Practical CFD modeling of synthetic air jets for thermal management of electronics", COGNITIVE INFORMATION PROCESSING (CIP), 2010 2ND INTERNATIONAL WORKSHOP ON, IEEE, PISCATAWAY, NJ, USA, 21 February 2010 (2010-02-21), pages 18-28, XP031655755, ISBN: 978-1-4244-6457-9

## Description

### BACKGROUND

The invention relates generally to thermal management systems, and more particularly, to thermal management systems with distributed jet cooling to augment convection heat transfer.

Recent advancements in electronics technology have produced nanometer sized electronic circuits. The resulting advanced electronics, although smaller, have higher heat fluxes. Because thermal real estate has been shrinking, advanced cooling techniques are needed. Cost, size, reliability, and availability have been major constraints.

Natural convection air-cooling is the method of choice for many low power electronics applications due to cost, availability, and reliability. However, its performance is limited due to buoyancy dependent flow. Therefore, there is a need for further enhancement of natural convection, in order to cool modern power electronics. Enhanced natural convection will allow higher heat dissipation and still largely maintain the simplicity of passive cooling.

Synthetic jets are small-scale turbulent jets formed from periodic suction and ejection of the ambient fluid. The jets may impinge upon a heat transfer surface enhancing convection cooling. Likewise, they may flow parallel to a heat transfer surface, also enhancing convection cooling. The small size of these devices, accompanied by a high air velocity, could enable a significant reduction in the size of thermal management hardware for power electronics. Synthetic jets are historically used for boundary layer control applications. However, they have also been shown to augment natural and forced convection heat transfer.

Although studies indicate that heat transfer augmentation is possible using synthetic jets, there is limited data available for the application of synthetic jets to large heat sink surfaces. In addition, new attachment means are needed for reliable attachment of synthetic jets to a chassis. Accordingly, it would be desirable to understand the interaction between main flow and synthetic jet flow and to exploit this interaction to achieve heat transfer enhancement for large heat sink surfaces, such as chassis cooling applications. It would further be desirable to provide reliable attachment means to attach synthetic jets to a chassis.

US 2010/0039012 describes an LED light source comprising a tabular synthetic jet ejector. EP 2 116 730 describes a component enclosure comprising a synthetic jet assembly. US 2008/0310110 describes a mounting apparatus for a cooling device. US 2003/155106 describes a heat sink apparatus with air duct. US 2008/023189 describes a heat exchanger. JP H05 251883 describes a cooling arrangement with fin plates and an exhaust fan.

### BRIEF DESCRIPTION

One aspect of the present invention resides in a chassis with distributed jet cooling, the chassis comprising one or more sidewalls defining a volume configured to substantially surround one or more heat generating components positioned within the volume. The chassis further includes at least one array of fins thermally coupled to a respective one of the one or more sidewalls and at least one synthetic jet assembly comprising a multi-orifice synthetic jet or a number of single orifice synthetic jets disposed on a side of a respective one of the array(s) of fins. The chassis further includes at least one attachment means for attaching a respective one of the at least one synthetic jet assemblies to a respective one of the one or more sidewalls. Another aspect of the invention resides in a chassis with distributed jet cooling, the chassis comprising one or more sidewalls defining a volume configured to substantially surround one or more heat generating components positioned within the volume and at least one array of fins thermally coupled to a respective one of the one or more sidewalls. The chassis further includes at least one synthetic jet assembly comprising a number of single orifice synthetic jets disposed on a side of a respective one of the array(s) of fins. The fins comprise plate fins arranged in a v-groove configuration.

### DRAWINGS

These and other features, aspects, and advantages of the present invention will become better understood when the following detailed description is read with reference to the accompanying drawings in which like characters represent like parts throughout the drawings, wherein:
FIG. 1 shows a chassis without a synthetic jet assembly;
FIG. 2 shows two sidewalls of the chassis equipped with respective synthetic jets assemblies;
FIG. 3 illustrates a snap-in configuration for attaching the synthetic jets to the chassis sidewalls;
FIG. 4 shows a c-clip holder, in perspective view;
FIG. 5 is a cross-sectional view of the arrangement shown in FIG. 3 and shows a row of slots formed in a sidewall for receiving e- or c-clip holders for the synthetic jets;
FIG. 6 illustrates a bent e-clip arrangement for attaching the synthetic jets to the chassis;
FIG. 7 illustrates another example arrangement for attaching the synthetic jets to the chassis;
FIG. 8 illustrates a rod-and-frame arrangement for attaching the synthetic jets to the chassis;
FIGS. 9(a)-(c) are top, front and back views of a first portion of a partially enclosed packaging arrangement for mounting the synthetic jets on the chassis;
FIG. 10(a) and (b) are a top view and a front/back view of a second portion of the partially enclosed packaging arrangement;
FIG. 11 is a front view of the assembled partially enclosed packaging arrangement;
FIG. 12 illustrates a synthetic jet package with diverted airflow that incorporates a symmetric plate;
FIG. 13 illustrates a two-plate configuration of the synthetic jet package shown in FIG. 12;
FIG. 14 depicts an example configuration for a multi-orifice synthetic jet for use in the chassis of FIG. 1;
FIG. 15 illustrates the operation of a single-orifice synthetic jet;
FIG. 16 further illustrates the operation of a single-orifice synthetic jet;
FIG. 17 illustrates a v-groove plate fin configuration;
FIG. 18 illustrates the spacing d between a synthetic jet and a fin;
FIG. 19 shows three different "on fin" arrangements of synthetic jets and fins;
FIGS. 20 shows an orifice for a jet with an opening length L; and
FIG. 21 is a cross section of FIG. 20 taken along AA.

### DETAILED DESCRIPTION

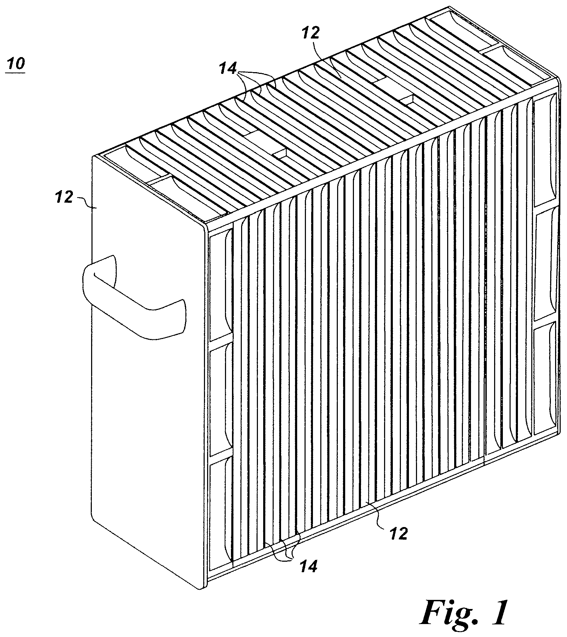

A chassis 10 with distributed jet cooling is described with reference to FIGS. 1-17. As shown for example in FIG. 1, the chassis 10 includes one or more sidewalls 12 defining a volume (not shown) configured to substantially surround one or more heat generating components (not shown) positioned within the volume. The heat generating components may be any component requiring cooling, non-limiting examples of which include high power processors and power electronics. The chassis further includes at least one array of fins 14 thermally coupled to a respective one of the one or more sidewalls 12. For the arrangement shown in FIG. 1, the fins 14 are longitudinal plate fins. However, other types of fins may be employed, including without limitation, pin fins. Briefly, the heat from the heat generating components is transferred into the sidewalls, which in turn transfer heat into the fins 14. The fins 14 increase the surface area for heat transfer for cooling the heat generating components.

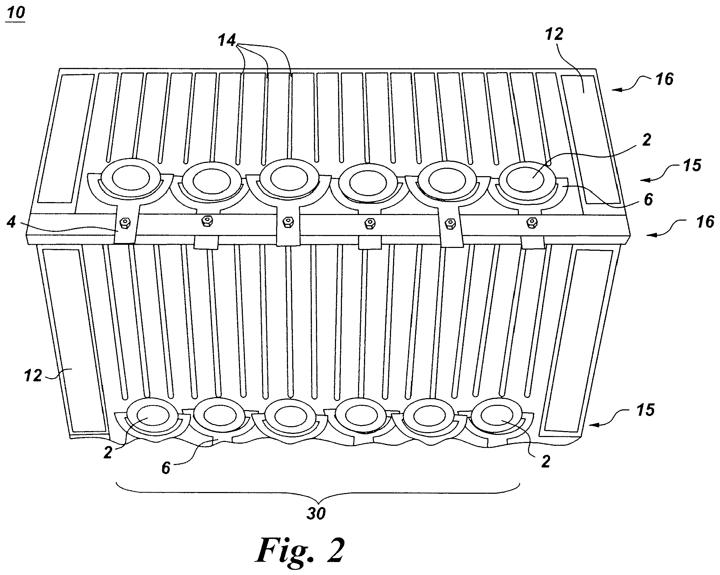

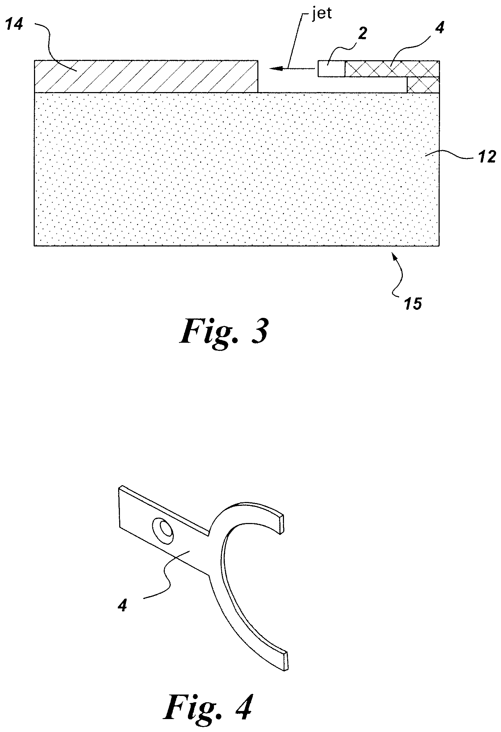

As shown in FIG. 2, for example, the chassis 10 further includes at least one synthetic jet assembly 30 comprising a multi-orifice synthetic jet (not shown in FIG. 2) or a number of single orifice synthetic jets 2 disposed on a side 15, 16 of a respective one of the at least one array of fins. For the example arrangement shown in FIG. 2, the synthetic jet assemblies 30 are disposed on the lower sides 15 of the respective arrays of plate fins 14. This example is illustrative, and the invention is not limited to this example configuration. In addition and as shown in FIG. 2, the chassis further includes at least one attachment means 4 for attaching a respective one of the at least one synthetic jet assemblies 30 (including the respective individual synthetic jets 2) to a respective one of the one or more sidewalls 12. The example attachment means 4 shown in FIG. 2 are merely illustrative, and a number of additional attachment arrangements are described below with reference to FIGS. 3-13. It should be noted that the invention is not limited to a specific attachment means.

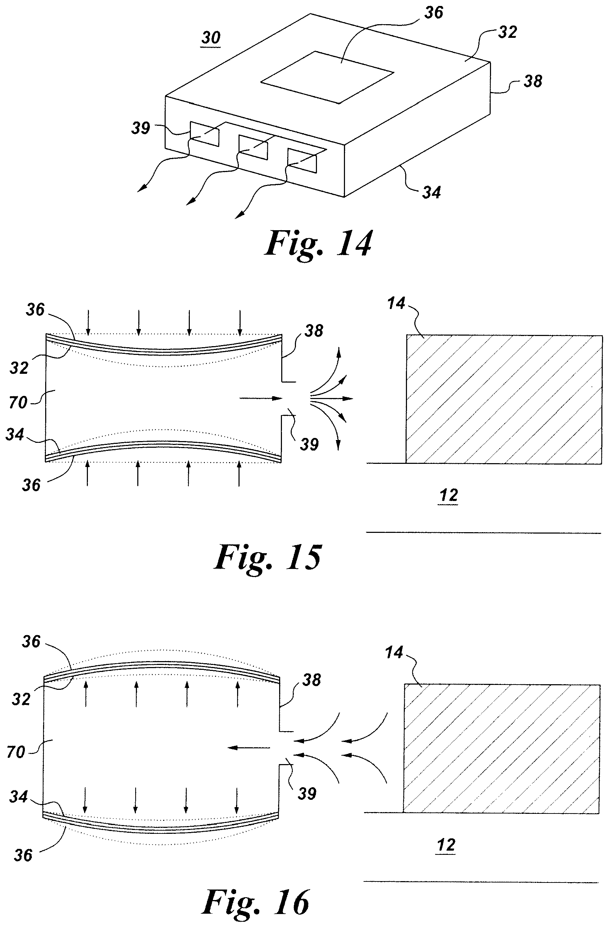

The operation of synthetic jets 2 can be understood with reference to FIGS. 15 and 16. As shown for example, in FIGS. 15 and 16, each of the synthetic jets 2 comprises a first flexible structure 32, a second flexible structure 34, at least one active material 36 coupled to at least one of the first and second flexible structures, and a compliant wall 38 positioned between the first and second flexible structures and defining a chamber. As indicated in FIGS. 15 and 16, the compliant wall 38 defines an orifice 39 for facilitating fluid communication between the chamber and an ambient environment of the fins 14.

In the illustrated arrangement of FIGS. 15 and 16, the active material 36 is positioned on the first flexible structure 32 and on the lower side of the second flexible structure 34. It should be noted that the locations of the active materials 36 on the flexible structures 32, 34 shown in the figures are purely illustrative, and the invention is not limited to any specific locations of active materials. Although for the arrangements shown in FIGS. 15 and 16, the active material is coextensive with the respective flexible structure, in other embodiments, the active material extends over only a portion of the flexible structure. For example, smaller diameter piezoelectric ceramic plates (not shown) may be disposed on flexible structures 32, 34 instead of coextensive active layers 36. The active material can take the form of a single continuous portion. Alternatively, multiple discontinuous portions of the active material can be employed to actuate respective ones of the flexible structures. A suitable active material is one, which is capable of creating stress resulting from an electrical stimulus. The flexible structures 32, 34 may comprise the same or different materials.

Examples of suitable active material include piezoelectric material, magnetostrictive material (magnetic fields from coils attract/oppose one another), shape-memory alloy, and motor imbalance (motor with a mass imbalance creates oscillatory motion). Within the subset of piezoelectric materials, suitable active materials include bimorph piezoelectric configurations, where two piezo layers are energized out of phase to produce bending; thunder configurations, where one piezo layer is disposed on a prestressed stainless steel shim; buzzer element configurations, where one piezo layer is disposed on a brass shim; and MFC configurations, where a piezo fiber composite on a flexible circuit is bonded to a shim. The active material may incorporate a ceramic material.

As schematically depicted in FIG. 2, a synthetic jet driver 40 is provided to apply an electrical current to the at least one active material 36, to form streams of ambient air. The synthetic jet driver 40 can be electrically coupled to the active material 36 using wires or flexible interconnects, for example. Briefly, electrical current from synthetic jet driver 40 is received by the active material, and transformed into mechanical energy. As shown, for example in FIG. 15, the active material 36 creates stress on the flexible walls 32, 34, causing them to flex inwardly, resulting in a chamber volume change and an influx of ambient air into the chamber 70, and then outwardly, thereby ejecting the ambient air from the chambers 70 via the orifice 39. Similarly, as illustrated in FIG. 16, when the active material 36 creates stress on the flexible chamber walls 32, 34 causing them to expand, resulting in another chamber volume change, ambient air is drawn into the chamber 70 via the orifice 39. In this manner, the driver 40 actuates the jets 30.

The synthetic jet driver 40 may be located within the chassis 10 or may be remotely located. In addition, the synthetic jet driver 40 may also be miniaturized and integrated with the synthetic jet. The current may be provided as a sine wave, a square wave, a triangular wave, or any other suitable waveform, and it should be appreciated that the current is not to be limited to any specific waveform. However, it has been found that currents having lower harmonics, such as, for example, a sine wave, may be used to provide a quieter synthetic jet 30. The voltage level for the electrical current may be between 1 and 150 volts but is not so limited. The frequency of the current may be between 2 and 300 hertz for embodiments requiring reduced noise, and between 300 hertz and 15 kilohertz for embodiments that do not require reduced noise levels.

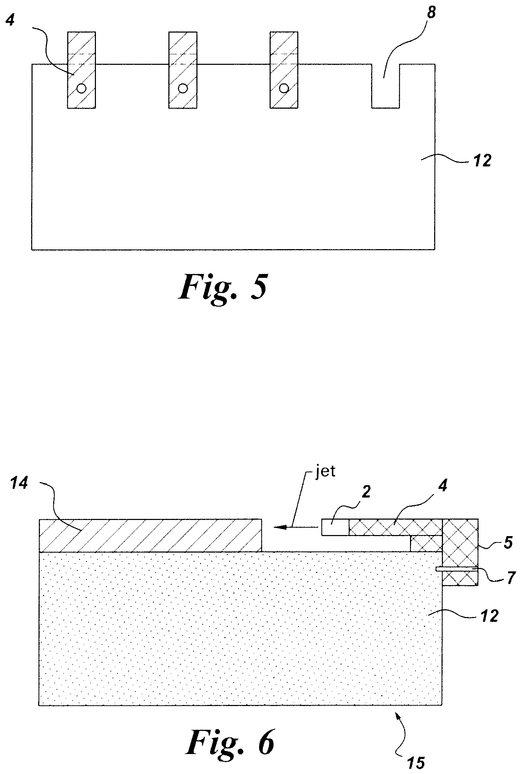

For many of the illustrated configurations, each of the synthetic jet assemblies 30 comprises a number of single orifice synthetic jets 2. For the particular attachment configuration shown in FIGS. 3 and 5, at least one of the sidewalls 12 includes a number of slots 8 disposed on at least one of the sides 15, 16 of the array of fins 14, and the attachment means 4 are configured for insertion into respective ones of the slots 8 and for securing each of the respective single orifice synthetic jets 2 to the respective slots 8. For the example arrangement shown in FIG. 5, one of the slots 8 is empty for illustrative purposes. The arrangement of FIGS. 3 and 5 may be implemented using c-clip attachment means. FIG. 4 shows an example c-clip 4 in perspective view. As indicated, for example, in FIG. 2, the synthetic jets 2 may be attached to the c-clip holders 4 by means of flexible connectors 6. In one non-limiting example, the flexible connectors 6 comprise silicone "ears." As indicated for example in FIG. 5, the base of the c-clip 4 is snapped into the slot 8 to securely mount the synthetic jet 2 to the chassis sidewall 12. To further secure the synthetic jets to the chassis, the c-clip holders 4 may be bolted to the sidewall, as indicated in FIG. 5 for example.

FIG. 6 illustrates another example arrangement for attaching the synthetic jets to the chassis. For the example arrangement of FIG. 6, each of the synthetic jet assemblies comprises a number of single orifice synthetic jets 2. However, for ease of illustration, only one jet 2 is shown in FIG. 2. In addition to the c-clip configuration discussed above with reference to FIGS. 3-5, e-clips may also be used to fasten respective ones of the single orifice synthetic jets 2 to the sidewalls 12. For the configuration shown in FIG. 6, the attachment means comprises a number of e-clips (also indicated by reference numeral 4). As indicated in FIG. 6, each of the e-clips 4 has a bent portion 5. As shown, each of the single orifice synthetic jets 2 is attached to a respective one of the e-clips 4, and the bent portion 5 of each of the e-clips 4 is fastened to a respective one of the sidewalls 12. For the example arrangement illustrated in FIG. 6, the bent portion 5 of each of the e-clips is fastened to the sidewall 12 using a bolt 7. The cross-sectional view for the arrangement of FIG. 6 is similar to that shown in FIG. 5 with the exception that no slots are needed for the arrangement of FIG. 6.

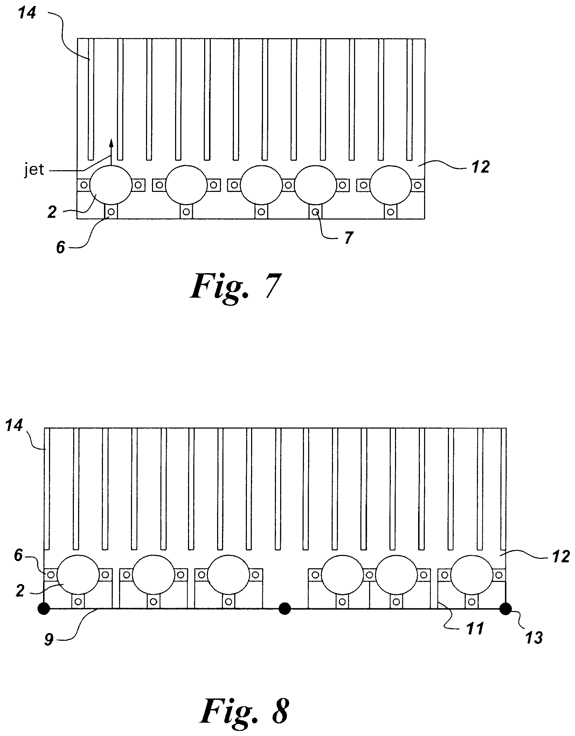

FIG. 7 illustrates yet another example arrangement for attaching the synthetic jets to the chassis. For the arrangement shown in FIG. 7, each of the synthetic jet assemblies comprises a number of single orifice synthetic jets 2, and the attachment means comprise a number of flexible portions 6. As indicated in FIG. 7, each of the single orifice synthetic jets 2 has at least one flexible portion 6 affixed thereto, and each of the flexible portions 6 is fastened to a respective one of the sidewalls 12. For the example arrangement illustrated in FIG. 7, each of the synthetic jets is attached to the sidewall by means of three flexible portions 6. However, for other arrangements, other numbers of flexible portions 6 may be employed. In one non-limiting example, the flexible portions 6 comprise silicone "ears." The ears may be attached to the respective sidewall with a rod or bolt 7, for example. As indicated in FIG. 7, there may be a gap or no gap between neighboring pairs of the "ears." According to a more particular example, at least one of the single orifice synthetic jets 2 is oriented at an angle relative to the fins 14. This may be accomplished, for example, by adjusting the height of the bolt used to affix the flexible portion to the sidewall.

FIG. 8 illustrates a rod-and-frame arrangement for attaching the synthetic jets to the chassis. For the arrangement shown in FIG. 8, each of the synthetic jet assemblies comprises a number of single orifice synthetic jets 2, and the attachment means comprise a frame 9 and a number of rods 11 attached to and extending from the frame 9. For the illustrated arrangement, each of the single orifice synthetic jets 2 is attached to two neighboring ones of the rods 11. According to a more particular arrangement, the attachment means further comprises a number of flexible portions 6, wherein each of the single orifice synthetic jets 2 has at least two flexible portions 6 affixed thereto, and wherein the single orifice synthetic jets 2 are attached to the rods 11 via the flexible portions 6. As noted above, one non-limiting example of the flexible portion 6 is a silicone "ear." For the specific arrangement shown in FIG. 8, each of the single orifice synthetic jets 2 has at least three flexible portions 6 affixed thereto. As shown, each of the single orifice synthetic jets 2 is attached directly to the frame 9 via a respective one of the flexible portions 6. In addition, the frame 9 may be affixed to the respective sidewall via rods/bolts 13, which are shown in top view in FIG. 8.

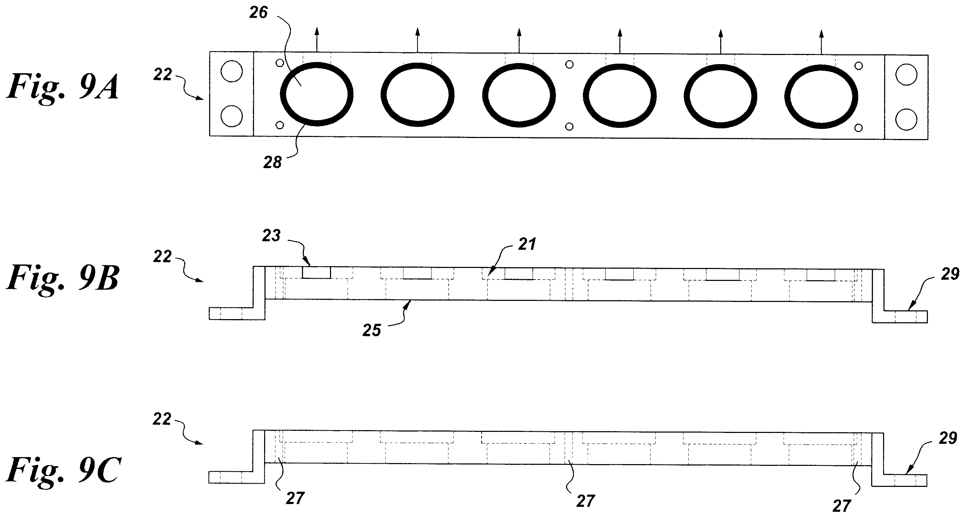

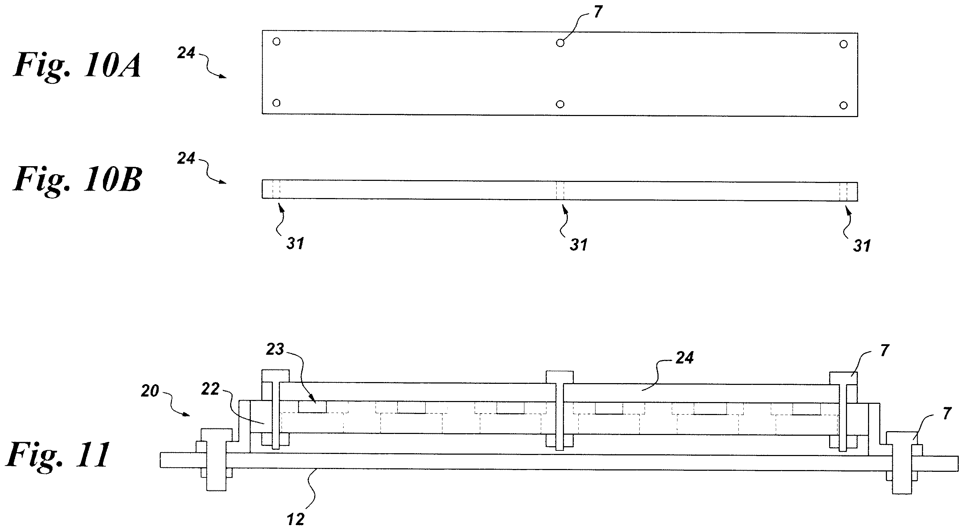

FIGS. 9(a)-(c), 10 (a) and (b) and 11 illustrate a partially enclosed packaging arrangement for mounting the synthetic jets on the chassis. For the arrangement shown in FIG. 11, each of the synthetic jet assemblies comprises a number of single orifice synthetic jets 2, and the attachment means comprise a partially enclosed package 20. Each of the single orifice synthetic jets 2 within a given synthetic jet assembly is disposed within the partially enclosed package 20.

For the example package configuration shown in FIGS. 9-11, the partially enclosed package 20 comprises a first portion 22 and a second portion 24. FIG. 9(a) is a top view of the first portion 22 of the package. Front and back views of the first portion 22 are shown in FIGS. 9(b) and 9(c), respectively. FIG. 10(a) is a top view of the second portion 24 of the package 20, and a front/back view of the second portion 24 is shown in FIG. 10(b). As shown for example in FIG. 9(a), the first portion 22 defines a number of openings 26 configured to receive respective ones of the single orifice synthetic jets (not shown). As shown for example in FIG. 11, after assembly, the second portion 24 is attached to the first portion 22 to cover the openings 26. For the example configuration shown in FIGS. 9-11, the second portion 24 is affixed to the first portion 22 by bolts 7.

As indicated in FIG. 9(a), for example, the illustrated partially enclosed package 20 further includes a number of gaskets 28. As shown, each of the gaskets 28 is disposed in a respective one of the openings 26 and accommodates a respective one of the single orifice synthetic jets 2. In one non-limiting example, the gaskets 28 are formed of silicone rubber. Beneficially, the gaskets shield the single orifice synthetic jets 2 from vibrations.

More particularly, and as shown in FIG. 9(b), the first portion 22 is recessed to provide recessed areas 21 for receiving respective ones of the jets and gaskets. In addition and as also shown in FIG. 9(b), openings 23 are provided for jet air, and holes 25 are provided within the first portion 22 for jet bellowing. The gaskets 28 position the jets in relation to the holes 25 and second portion 24 to obtain the needed volume for jet bellowing. For the example configuration shown in FIGS. 9(a)-(c), holes 27 are provided in the first portion 22 for bolting the first and the second portions 22, 24 together to form the package 20, as indicated in FIG. 9(c). In addition, holes 29 are formed in the ends of the first portion for bolting the package to the respective chassis sidewall 12, for the example arrangement shown in FIG. 9(c). Similarly, and as indicated in FIGS. 10 (a) and (b), holes 31 are formed in the second portion 24 for receiving the bolts 7. As shown for example in FIG. 11, the partially enclosed package 20 may be attached to a respective one of the sidewalls 12, for example with bolts 7. In addition, a vibration damper (or shock absorbing spacers, not shown) may be disposed between the package 20 and the respective chassis sidewall 12.

The invention embraces a number of modifications to the partially enclosed package. For example, replace the "L" shaped foot brackets in the example configuration of FIG. 11 may be replaced with a spacer or bushing made of a soft rubber (or Si) for shock absorption. Another option is to remove the L shaped bracket completely and extend the bolts used to attach the first and second portions through to the chassis sidewall to attach the package to the chassis sidewall.

In addition, an open version of the package 20 may be employed for weight reduction. For this arrangement, only enough material is used to form the first and second portions 22, 24 of the package to hold together structurally. This open version can be structured as a triangular lattice shape with six "ring" holders for the jets.

In addition, a variety of electrical connections (not shown) may be employed for powering the synthetic jets. The invention is not limited to any specific electrical connection configuration. In one example arrangement, a groove (not shown) is cast in the second portion 24 to accept wires from jets and route them to a connection outside the chassis. In another example arrangement, a groove is cast in the second portion 24 for routing wires together. While still in the package, the wires are routed down towards the chassis, for example, through alignment holes in the chassis and bottom part of the package. In this case, the drive electronics (not shown) would be internal to the chassis.

In yet another example arrangement for the electrical connections for the synthetic jets, the jets are equipped with a relatively small, secure set of leads, which terminate in a robust terminal pad (not shown). For this arrangement, the first portion 22 of the package 20 includes an area adjacent to the jet cut-out area with a cut-out (or recession) for the terminal pad. The second portion 24 of the package 20 includes matching pads and embedded wires (and for particular embodiments, printed circuit board type connections) to the terminal pad to the drive electronics. For this configuration, the drive electronics (not shown) are external to the chassis. However, this arrangement may be modified for use with drive electronics internal to the chassis. In this case, the wiring is on the first portion 22 of the package 20, to facilitate routing the wires into the chassis.

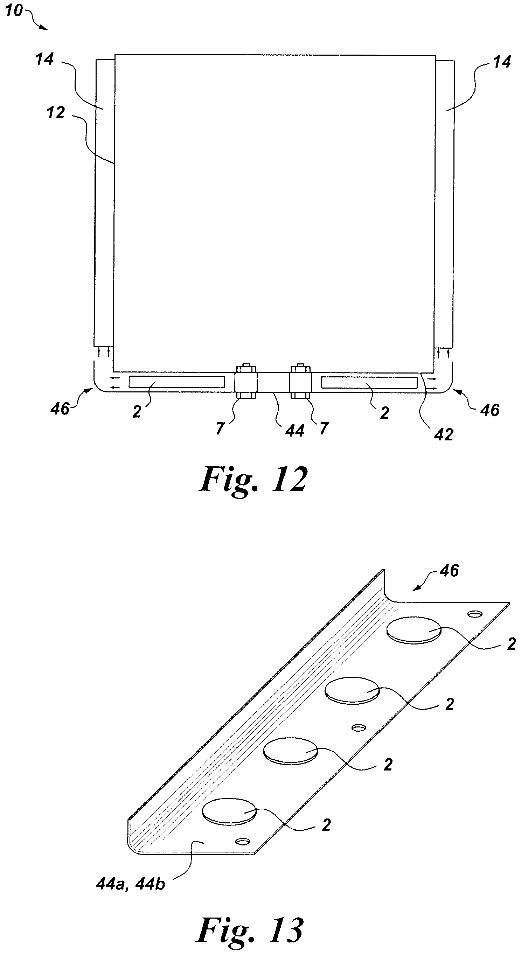

FIGS. 12 and 13 illustrate another configuration for attaching the synthetic jets 2 to the chassis sidewalls, in which the airflow is diverted. For the arrangement shown in FIG. 12, a lower 42 one of the sidewalls 12 does not have an array of fins, and the attachment means comprises at least one plate 44 mounted to the lower sidewall 42. As indicated in FIG. 12, at least one of the single orifice synthetic jets 2 is mounted to the plate 44 and oriented to direct a jet outwards, and the plate 44 has at least one bent portion 46 for guiding the jet around a corner of the chassis for incidence upon the array of fins 14 on a neighboring one of the sidewalls 12.

For the particular arrangement shown in FIG. 12, the attachment means comprises one plate 44 mounted to the lower sidewall 42. For the arrangement shown in FIG. 12, the plate 44 is attached to the lower sidewall 42 with bolts 7. At least two of the single orifice synthetic jets 2 are mounted to the plate 44 and oriented to direct respective jets outwards in opposite directions, as indicated in FIG. 12. For the specific arrangement shown in FIG. 12, the plate 44 has two bent portions 46 for guiding respective ones of the jets around the respective corner of the chassis for incidence upon the array of fins 14 on respective neighboring ones of the sidewalls 12.

According to a particular arrangement, a number of the single orifice synthetic jets 2 may be mounted to the plate 44 and oriented to direct respective jets outwards in a first direction, and a number of the single orifice synthetic jets 2 may be mounted to the plate 44 and oriented to direct respective jets outwards in a second direction. Although not expressly shown in FIG. 12, this is similar to the arrangement shown in FIG. 13 but with rows of jets 2 on either end of a symmetric plate 44.

Although FIG. 12 shows a single symmetric plate 44, this concept may also be implemented with two plates 44a,b, as indicated in FIG. 13. For the two-plate configuration, the attachment means comprises a first plate 44a and a second plate 44b mounted to the lower sidewall 42. The plates 44a,b may be bolted to the lower sidewall, similar to the arrangement shown in FIG. 12. As indicated in FIG. 13, at least one of the single orifice synthetic jets 2 is mounted to the first plate 44a. Similar to the arrangement shown in FIG. 12, the one or more jets are oriented to direct a jet outwards in a first direction. Similarly, at least one of the single orifice synthetic jets 2 is mounted to the second plate 44b and oriented to direct a jet outwards in a second direction. The relative orientation of the jets is the same as that shown in FIG. 12. Each of the first and second plates 44a,b has a bent portion 46 for guiding the respective jet around the respective corner of the chassis for incidence upon the array of fins 14 on the respective neighboring one of the sidewalls 12.

For the particular arrangement shown in FIG. 13, a number of the single orifice synthetic jets 2 are mounted to the first plate 44a and oriented to direct respective jets outwards in the first direction, and a number of the single orifice synthetic jets 2 are mounted to the second plate 44b and oriented to direct respective jets outwards in the second direction. The relative orientation of the jets is the same as that shown in FIG. 12. Beneficially, it is not necessary to remove portions of the fins 14 with the arrangements illustrated by FIGS. 12 and 13 because the jets 2 are mounted on the lower sidewall 42. In addition, the angle at which the bent portions are bent may be selected to adjust the angle between the air flow from the jets and the end surface of the fins 14. In addition the spacing between the plate(s) and the lower sidewall may be adjusted to adjust the relevant distance between the end surface of the fins and the vertical airflow.

As noted above, in addition to the single orifice synthetic jets 2, the synthetic jet assemblies may comprise multi-orifice synthetic jets 30, which are illustrated in FIG. 14. In addition, each synthetic jet assembly may comprise a stack (not shown) of the single or multi-orifice synthetic jets 30, for example as described in commonly assigned U.S. Patent Application Ser. No. 12/421,068, M. Arik et al., "Heat Sinks with Distributed and Integrated Jet Cooling". As shown for example in FIG. 14, a multi-orifice synthetic jet 30 comprises a first flexible structure 32, a second flexible structure 34, at least one active material 36 coupled to at least one of the first and second flexible structures, and a compliant wall 38 positioned between the first and second flexible structures and defining a chamber. As indicated in FIG. 14, the compliant wall defines multiple orifices 39 for facilitating fluid communication between the chamber and an ambient environment of the fins 14. It should be noted that the number of orifices shown in FIG. 14 is merely illustrative and is non-limiting. In one non-limiting example, the compliant wall 38 comprises an elastomer. Other example materials for the compliant wall 38 include, without limitation, polymers, glues, adhesives, metals, and composites.

In the illustrated arrangement of FIG. 14, the active material 36 is positioned on both of the first and second flexible structures 32, 34. It should be noted that the locations of the active materials 36 on the flexible structures 32, 34 shown in the figures are purely illustrative, and the invention is not limited to any specific locations of active materials. In particular embodiments, the active material is coextensive with the respective flexible structure. In other embodiments, the active material extends over only a portion of the flexible structure. The active material can take the form of a single continuous portion. Alternatively, multiple discontinuous portions of the active material can be employed to actuate respective ones of the flexible structures. A suitable active material is one, which is capable of creating stress resulting from an electrical stimulus. Examples of suitable active material are provided above with reference to FIGS. 15 and 16.

As discussed above with reference to FIG. 2, a synthetic jet driver 40 may be provided to apply an electrical current to the at least one active material 36, to form streams of ambient air. The synthetic jet driver 40 may be located within the chassis or may be remotely located.

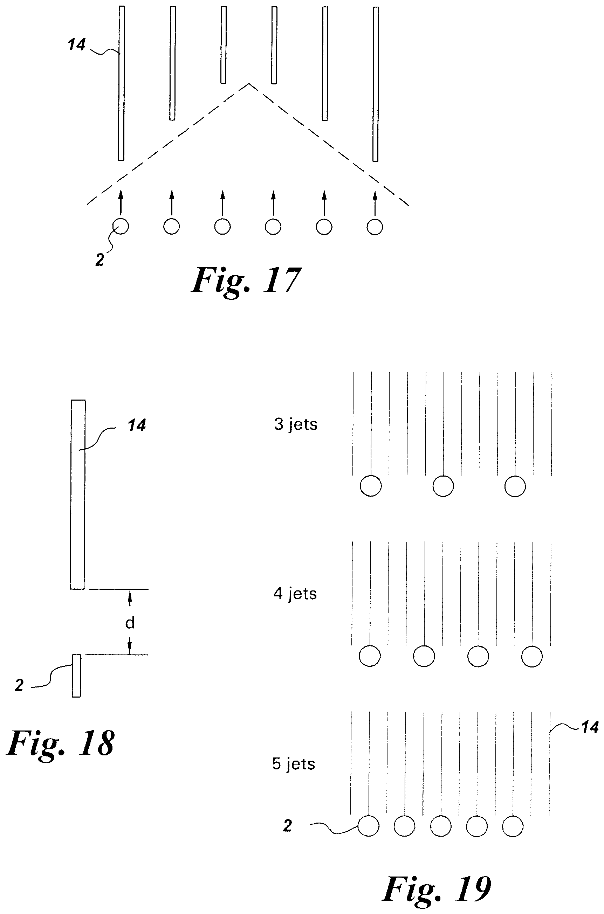

A number of different fin configurations can be employed in the above-described chassis. For the arrangements depicted in FIGS. 1 and 2, the fins are plate fins arranged in a regular one-dimensional array. FIG. 17 illustrates a v-groove plate fin configuration. Under specific circumstances, a v-groove configuration may exhibit enhanced cooling relative to a conventional plate fin arrangement shown for example in FIGS. 1 and 2. It should be noted that although FIG. 17 shows a v-groove configuration with symmetric v-grooves, the invention is not limited to these arrangements and can also employ asymmetric v-groove configurations. Similarly, although FIG. 17 shows v-grooves with centerlines aligned with the respective centerlines of the jets, offset arrangements may also be employed, in which the centerlines of the v-grooves are offset from the centerlines of the jets. Similarly, combinations of these arrangements may also be employed (asymmetric v-grooves that are offset for the respective jets).

Particular features of chassis 10 with distributed jet cooling are described with reference to FIGS. 15, 16, 18 and 19. As discussed above with reference to FIGS 1 and 2, the chassis 10 includes one or more sidewalls 12 defining a volume (not shown) configured to substantially surround one or more heat generating components not shown) positioned within the volume. The chassis 10 further includes at least one array of fins 14 thermally coupled to a respective one of the one or more sidewalls and at least one synthetic jet assembly 30 comprising a number of single orifice synthetic jets 2 disposed on a side 15, 16 of a respective one of the at least one array of fins. As indicated, for example in FIG. 15, each of the single orifice synthetic jets 2 is configured to direct a jet at an end of a respective one of the fins 14 (an "on fin" configuration). Beneficially, experimental test results showed that on fin configurations (jet exit centerline is aligned with the respective fin) exhibited enhanced cooling performance relative to arrangements in which the jets were directed between neighboring fins.

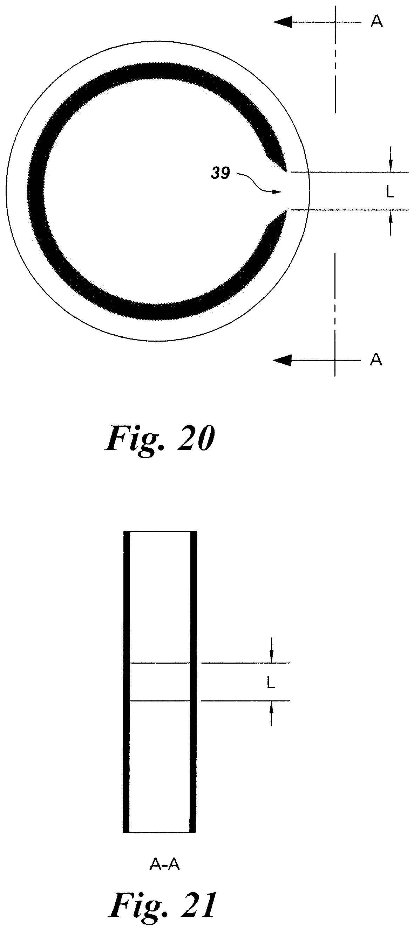

As indicated, for example in FIGS. 15 and 16, each of the single orifice jets 2 comprises an orifice. For particular embodiments, at least a subset of the orifices have an opening length L in a range of about three (3) millimeters (mm) to about seventeen (17) mm, and the distance d (see, for example, FIG. 18) between a respective one of the orifices and the respective end of the fin is in a range of about one millimeter (mm) to about seven (7) mm. As shown for example, in FIGS. 20 and 21, the opening length L for the orifice 39 is the length of the chord formed by the ends of the walls (for example, silicon walls) that define the orifice. Thus, looking "head on" at the jet (facing the orifice), the opening length L is the 2-D length of the opening. More generally, the orifice size is selected to be proportional to the fin spacing to achieve optimal cooling, and to provide adequate cooling/vortex generation, the jets are optimally located with the fins. According to a more particular embodiment, at least a subset of the orifices have an opening length L in a range of about eight (8) mm to about seventeen (17) mm, and still more particularly, in a range of about thirteen (13) mm to about seventeen (17) mm. Experimental test results showed that 15 mm orifice jets exhibited enhanced cooling performance relative to 8 mm orifice jets.

According to a more particular embodiment, the distance d is in a range of about one millimeter (mm) to about 3 mm. In one non-limiting example the distance d between the orifice and the end of the fin is about two millimeters. As used here, the term "about" should be construed to mean within plus/minus ten percent of the stated value. Experimental test results showed similar cooling for jets spaced 10 mm and 2 mm from the respective fins. Hence, a two (2) mm spacing is preferred to reduce the space taken by jet mountings.

FIG. 19 shows three different "on fin" arrangements of synthetic jets and fins 24. For the first configuration shown in FIG. 19 (labeled "3 jets"), each synthetic jet assembly comprises three single orifice synthetic jets 2, and the spacing between neighboring single orifice synthetic jets is every fourth fin. More generally, an integer number N of single orifice synthetic jets 2 may be used, where the spacing between neighboring single orifice synthetic jets is every fourth fin. For the first configuration shown in FIG. 19, N=3. For a chassis that is two times as wide as the tested heat sink, N= 6, for example. As shown for example in FIG. 19, the phrase "every fourth fin" should be understood to mean every fourth fin for the case of a one-dimensional array of plate fins. Similarly, this refers to every fourth row of fins for the case of a two-dimensional array of pin fins.

For the second configuration shown in FIG. 19 (labeled "4 jets"), each synthetic jet assembly comprises four single orifice synthetic jets 2, and the spacing between neighboring single orifice synthetic jets 2 is every third fin. More generally, an integer number N of single orifice synthetic jets 2 may be used, where the spacing between neighboring single orifice synthetic jets is every third fin. For the second configuration shown in FIG. 19, N=4. For a chassis that is 150% as wide as the tested heat sink, N= 6, for example. As shown for example in FIG. 19, the phrase "every third fin" should be understood to mean every third fin for the case of a one dimensional array of plate fins and every third row of fins for the case of a two dimensional array of pin fins.

For the third configuration shown in FIG. 19 (labeled "5 jets"), each synthetic jet assembly comprises five single orifice synthetic jets 2, and the spacing between neighboring single orifice synthetic jets 2 is every other fin. More generally, an integer number N of single orifice synthetic jets 2 may be used, where the spacing between neighboring single orifice synthetic jets is every other fin. For the second configuration shown in FIG. 19, N=5. However, the specific value of N may vary. As shown for example in FIG. 19, the phrase "every other fin" should be understood to mean every other fin for the case of plate fins and every other row of fins for the case of a two dimensional array of pin fins.

Although cooling enhancement increases with the number of jets, this trend decreases with increasing number of jets. Switching from three jets to four jets, the overall enhancement changes from 2.5 to 3.2, rising by 0.7, whereas it increases by 0.3 when switching from four jets to five jets. This indicates decrease of COP (coefficient of performance) as the number of jets increases. COP in the present work is defined as the ratio of heat dissipation to power consumption of synthetic jets. These results were obtained for a series of multiple jet tests for on-fin arrangements using synthetic jets with 15 mm orifices that were placed two mm below a finned plate. For these arrangements, switching from three jets to four jets caused COP to slightly decrease from 49 to 47. However, switching from four jets to five jets caused COP to decrease from 47 to 42. Beneficially, using four jets achieved 300% enhancement over natural convection with a coefficient of performance of 47.

Although only certain features of the invention have been illustrated and described herein, many modifications and changes will occur to those skilled in the art. It is, therefore, to be understood that the appended claims are intended to cover all such modifications and changes.

## Claims

1. A chassis (10) with distributed jet cooling, the chassis comprising:
one or more sidewalls (12) defining a volume configured to substantially surround one or more heat generating components positioned within the volume;
at least one array of fins (14) thermally coupled to a respective one of the one or more sidewalls;
at least one synthetic jet assembly (30) comprising a multi-orifice synthetic jet (30) or a plurality of single orifice synthetic jets (2) disposed on a side (15, 16) of a respective one of the at least one array of fins; and
at least one attachment means (4, 6, 9, 11, 20, 44) for attaching a respective one of the at least one synthetic jet assemblies to a respective one of the one or more sidewalls;
wherein the fins (14) comprise plate fins (14) arranged in a v-groove configuration in which:
(i) center lines of the plate fins (14) are parallel with center lines of the jets (2, 30);
(ii) distances (d) between a respective jet (2, 30) and a respective plate fin (14) increase from an edge towards a center of the array of fins (14);
(iii) the jets (2, 30) are arranged along a line that is perpendicular to the center lines of the plate fins (14); and
(iv) lengths of respective plate fins (14) decrease from an edge towards a center of the array of fins (14).

2. The chassis (10) of claim 1, wherein the at least one synthetic jet assembly (30) comprises a plurality of single orifice synthetic jets (2), wherein at least one of the sidewalls (12) includes a plurality of slots (8) disposed on at least one of the sides (15, 16) of the array of fins (14), and wherein the at least one attachment means are configured for insertion into respective ones of the slots and for securing the respective single orifice synthetic jet to the slot.

3. The chassis (10) of claim 1, wherein the at least one synthetic jet assembly (30) comprises a plurality of single orifice synthetic jets (2), wherein the at least one attachment means comprises a plurality of clips (4) each of the clips having a bent portion (5), wherein each of the single orifice synthetic jets is attached to a respective one of the clips, and wherein the bent portion of each of the clips is fastened to a respective one of the one or more sidewalls (12).

4. The chassis (10) of claim 1, wherein the at least one synthetic jet assembly (30) comprises a plurality of single orifice synthetic jets (2), wherein the at least one attachment means comprises a plurality of flexible portions (6), wherein each of the single orifice synthetic jets has at least one flexible portion affixed thereto, and wherein each of the flexible portions is fastened to a respective one of the one or more sidewalls (12), and wherein at least one of the single orifice synthetic jets (2) is oriented at an angle relative to the fins (14).

5. The chassis (10) of claim 1, wherein the at least one synthetic jet assembly (30) comprises a plurality of single orifice synthetic jets (2), wherein the attachment means comprises a frame (9) and a plurality rods (11) attached to and extending from the frame, wherein each of the single orifice synthetic jets is attached to two neighboring ones of the rods, wherein the attachment means further comprises a plurality of flexible portions (6), wherein each of the single orifice synthetic jets has at least two flexible portions affixed thereto, and wherein the single orifice synthetic jets are attached to the rods (11) via the flexible portions.

6. The chassis (10) of claim 1, wherein the at least one synthetic jet assembly (30) comprises a plurality of single orifice synthetic jets (2), wherein the attachment means comprises a partially enclosed package (20), wherein each of the single orifice synthetic jets is disposed within the partially enclosed package,
wherein the partially enclosed package (20) comprises a first portion (22) and a second portion (24), wherein the first portion defines a plurality of openings (26) configured to receive respective ones of the single orifice synthetic jets (2), wherein the second portion is attached to the first portion to cover the openings,
wherein the partially enclosed package (20) further comprises a plurality of gaskets (28), each of the gaskets being disposed in a respective one of the openings and accommodating a respective one of the single orifice synthetic jets (2), and wherein the partially enclosed package is attached to a respective one of the sidewalls (12).

7. The chassis (10) of claim 1, wherein a lower (42) one of the sidewalls (12) does not have an array of fins, wherein the attachment means comprises at least one plate (44) mounted to the lower sidewall, wherein at least one of the single orifice synthetic jets (2) is mounted to the plate and oriented to direct a jet outwards, and wherein the plate has at least one bent portion for guiding the jet around a corner of the chassis for incidence upon the array of fins on a neighboring one of the sidewalls, or
wherein the attachment means comprises one plate (44) mounted to the lower sidewall, wherein at least two of the single orifice synthetic jets (2) are mounted to the plate and oriented to direct respective jets outwards in opposite directions, and wherein the plate has two bent portions for guiding respective ones of the jets around the respective corner of the chassis for incidence upon the array of fins on respective neighboring ones of the sidewalls.

8. The chassis (10) of claim 1, wherein a lower (42) one of the sidewalls (12) does not have an array of fins, wherein the attachment means comprises at least one plate (44) mounted to the lower sidewall, wherein at least one of the single orifice synthetic jets (2) is mounted to the plate and oriented to direct a jet outwards, and wherein the plate has at least one bent portion for guiding the jet around a corner of the chassis for incidence upon the array of fins on a neighboring one of the sidewalls,
wherein the attachment means comprises a first plate (44a) and a second plate (44b) mounted to the lower sidewall, wherein at least one of the single orifice synthetic jets (2) is mounted to the first plate and oriented to direct a jet outwards in a first direction, wherein at least one of the single orifice synthetic jets is mounted to the second plate and oriented to direct a jet outwards in a second direction, and wherein each of the first and second plates has a bent portion for guiding the respective jet around the respective corner of the chassis for incidence upon the array of fins on the respective neighboring one of the sidewalls.

9. The chassis (10) of claim 1, wherein each of the multi-orifice synthetic jets comprises:
a first flexible structure (32);
a second flexible structure (34);
at least one active material (36) coupled to at least one of the first and second flexible structures; and
a compliant wall (38) positioned between the first and second flexible structures and defining a chamber, wherein the compliant wall defines a plurality of orifices (39) for facilitating fluid communication between the chamber and an ambient environment of the fins.

10. The chassis of claim 1, wherein at least a subset of the orifices have an opening length L in a range of about 8mm to about 17mm.

11. The chassis of claim 2, wherein at least a subset of the orifices have an opening length L in a range of about 13mm to about 17mm.

## Patentansprüche

1. Gehäuse (10) mit verteilter Strahlkühlung, wobei das Gehäuse Folgendes umfasst:
eine oder mehrere Seitenwände (12), die ein Volumen definieren, das konfiguriert ist, um eine oder mehrere wärmeerzeugende Komponenten, die innerhalb des Volumens positioniert sind, im Wesentlichen zu umgeben;
wenigstens eine Rippenanordnung (14), die thermisch mit einer jeweiligen einen der einen oder der mehreren Seitenwände gekoppelt ist;
wenigstens eine Baugruppe synthetischer Strahlen (30), die einen synthetischen Strahl mit mehreren Öffnungen (30) oder mehrere synthetische Strahlen mit einer einzelnen Öffnung (2) umfasst, die auf einer Seite (15, 16) einer jeweiligen einen der wenigstens einen Rippenanordnung eingerichtet sind; und
wenigstens ein Befestigungsmittel (4, 6, 9, 11, 20, 44) zum Befestigen einer jeweiligen einen der wenigstens einen Baugruppe synthetischer Strahlen an einer jeweiligen einen der einen oder der mehreren Seitenwände;
wobei die Rippen (14) Plattenrippen (14) umfassen, die in einer V-Nut-Konfiguration angeordnet sind, wobei:
(i) Mittellinien der Plattenrippen (14) parallel zu den Mittellinien der Strahlen (2, 30) verlaufen;
(ii) Abstände (d) zwischen einem jeweiligen Strahl (2, 30) und einer jeweiligen Plattenrippe (14) von einer Kante zu einer Mitte der Rippenanordnung (14) zunehmen;
(iii) die Strahlen (2, 30) entlang einer Linie angeordnet sind, die senkrecht zu den Mittellinien der Plattenrippen (14) verlaufen; und
(iv) Längen der jeweiligen Plattenrippen (14) von einer Kante zu einer Mitte der Rippenanordnung (14) abnehmen.

2. Gehäuse (10) nach Anspruch 1, wobei die wenigstens eine Baugruppe synthetischer Strahlen (30) mehrere synthetische Strahlen mit einer einzelnen Öffnung (2) umfasst, wobei wenigstens eine der Seitenwände (12) mehrere Schlitze (8) beinhaltet, die auf wenigstens einer der Seiten (15, 16) der Rippenanordnung (14) eingerichtet ist, und wobei das wenigstens eine Befestigungsmittel zum Einführen in die jeweiligen einen der Schlitze und zum Sichern des jeweiligen synthetischen Strahls mit einer einzelnen Öffnung an dem Schlitz konfiguriert ist.

3. Gehäuse (10) nach Anspruch 1, wobei die wenigstens eine Baugruppe synthetischer Strahlen (30) mehrere synthetische Strahlen mit einer einzelnen Öffnung (2) umfasst, wobei das wenigstens eine Befestigungsmittel mehrere Klammern (4) umfasst, wobei jede der Klammern einen gebogenen Abschnitt (5) aufweist, wobei jeder der synthetischen Strahlen mit einer einzelnen Öffnung an einer jeweiligen einen der Klammern befestigt ist und wobei der gebogene Abschnitt jeder Klammer an einer jeweiligen einen der einen oder der mehreren Seitenwände (12) fixiert ist.

4. Gehäuse (10) nach Anspruch 1, wobei die wenigstens eine Baugruppe synthetischer Strahlen (30) mehrere synthetische Strahlen mit einer einzelnen Öffnung (2) umfasst, wobei das wenigstens eine Befestigungsmittel mehrere flexible Abschnitte (6) umfasst, wobei jeder der synthetischen Strahlen mit einer einzelnen Öffnung wenigstens einen daran angebrachten flexiblen Abschnitt aufweist und wobei jeder der flexiblen Abschnitte an einer jeweiligen einen der einen oder der mehreren Seitenwände (12) fixiert ist und wobei wenigstens einer der synthetischen Strahlen mit einer einzelnen Öffnung (2) in einem Winkel relativ zu den Rippen (14) ausgerichtet ist.

5. Gehäuse (10) nach Anspruch 1, wobei die wenigstens eine Baugruppe synthetischer Strahlen (30) mehrere synthetische Strahlen mit einer einzelnen Öffnung (2) umfasst, wobei das Befestigungsmittel einen Rahmen (9) und mehrere Stangen (11) umfasst, die an dem Rahmen befestigt sind und sich aus diesem erstrecken, wobei jeder der synthetischen Strahlen mit einer einzelnen Öffnung an zwei benachbarten Stangen befestigt ist, wobei das Befestigungsmittel ferner mehrere flexible Abschnitte (6) umfasst, wobei jeder der synthetischen Strahlen mit einer einzelnen Öffnung wenigstens zwei daran angebrachte flexible Abschnitte aufweist und wobei die synthetischen Strahlen mit einer einzelnen Öffnung über die flexiblen Abschnitte an den Stangen (11) befestigt sind.

6. Gehäuse (10) nach Anspruch 1, wobei die wenigstens eine Baugruppe synthetischer Strahlen (30) mehrere synthetische Strahlen mit einer einzelnen Öffnung (2) umfasst, wobei das Befestigungsmittel eine teilweise eingeschlossene Einheit (20) umfasst, wobei jeder der synthetischen Strahlen mit einer einzelnen Öffnung innerhalb der teilweise eingeschlossenen Einheit eingerichtet ist,
wobei die teilweise eingeschlossene Einheit (20) einen ersten Abschnitt (22) und einen zweiten Abschnitt (24) umfasst, wobei der erste Abschnitt mehrere Durchlässe (26) definiert, die konfiguriert sind, um jeweilige der synthetischen Strahlen mit einer einzelnen Öffnung (2) aufzunehmen, wobei der zweite Abschnitt an dem ersten Abschnitt befestigt ist, um die Durchlässe abzudecken,
wobei die teilweise eingeschlossene Einheit (20) ferner mehrere Dichtungen (28) umfasst, wobei jede der Dichtungen in einem jeweiligen einen der Durchlässe eingerichtet ist und einen jeweiligen einen der synthetischen Strahlen mit einer einzelnen Öffnung (2) fasst, und wobei die teilweise eingeschlossene Einheit an einer jeweiligen einen der Seitenwände (12) befestigt ist.

7. Gehäuse (10) nach Anspruch 1, wobei eine untere (42) eine der Seitenwände (12) keine Rippenanordnung aufweist, wobei das Befestigungsmittel wenigstens eine Platte (44) umfasst, die an der unteren Seitenwand montiert ist, wobei wenigstens einer der synthetischen Strahlen mit einer einzelnen Öffnung (2) an der Platte montiert und ausgerichtet ist, um einen Strahl nach außen auszurichten, und wobei die Platte wenigstens einen gebogenen Abschnitt zum Führen des Strahls um eine Ecke des Gehäuses für ein Auftreffen auf die Rippenanordnung auf einer benachbarten einen der Seitenwände aufweist oder
wobei das Befestigungsmittel eine Platte (44) umfasst, die an der unteren Seitenwand montiert ist, wobei wenigstens zwei der synthetischen Strahlen mit einer einzelnen Öffnung (2) an der Platte montiert und ausgerichtet sind, um jeweilige Strahlen in entgegengesetzte Richtungen nach außen zu lenken, und wobei die Platte zwei gebogene Abschnitte zum Führen jeweiliger der Strahlen um die jeweilige Ecke des Gehäuses für das Auftreffen auf die Rippenanordnung auf jeweiligen benachbarten der Seitenwände aufweist.

8. Gehäuse (10) nach Anspruch 1, wobei eine untere (42) der Seitenwände (12) keine Rippenanordnung aufweist, wobei das Befestigungsmittel wenigstens eine Platte (44) umfasst, die an der unteren Seitenwand montiert ist, wobei wenigstens einer der synthetischen Strahlen mit einer einzelnen Öffnung (2) an der Platte montiert und ausgerichtet ist, um einen Strahl nach außen zu lenken, und wobei die Platte wenigstens einen gebogenen Abschnitt zum Führen des Strahls um die Ecke des Gehäuses für das Auftreffen auf die Rippenanordnung auf einer benachbarten einen der Seitenwände aufweist,
wobei das Befestigungsmittel eine erste Platte (44a) und eine zweite Platte (44b) umfasst, die an der unteren Seitenwand montiert sind, wobei wenigstens einer der synthetischen Strahlen mit einer einzelnen Öffnung (2) an der ersten Platte montiert und ausgerichtet ist, um einen Strahl in einer ersten Richtung nach außen zu lenken, wobei wenigstens einer der synthetischen Strahlen mit einer einzelnen Öffnung an der zweiten Platte montiert und ausgerichtet ist, um einen Strahl in einer zweiten Richtung nach außen zu lenken, und wobei jede der ersten und der zweiten Platten einen gebogenen Abschnitt zum Führen des jeweiligen Strahls um die jeweilige Ecke des Gehäuse für das Auftreffen auf die Rippenanordnung auf der jeweiligen benachbarten einen der Seitenwände aufweist.

9. Gehäuse (10) nach Anspruch 1, wobei jede der synthetischen Strahlen mit mehreren Öffnungen Folgendes umfasst:
eine erste flexible Struktur (32);
eine zweite flexible Struktur (34);
wenigstens ein aktives Material (36), das mit der ersten und/oder der zweiten flexiblen Struktur gekoppelt ist; und
eine nachgebende Wand (38), die zwischen der ersten und der zweiten flexiblen Struktur positioniert ist und eine Kammer definiert, wobei die nachgebende Wand mehrere Öffnungen (39) zum Ermöglichen einer Fluidverbindung zwischen der Kammer und einer Raumumgebung der Rippen definiert.

10. Gehäuse nach Anspruch 1, wobei wenigstens eine Teilmenge der Öffnungen eine Durchlasslänge L in einem Bereich von etwa 8 mm bis etwa 17 mm aufweist.

11. Gehäuse nach Anspruch 2, wobei wenigstens eine Teilmenge der Öffnungen eine Durchlasslänge L in einem Bereich von etwa 13 mm bis etwa 17 mm aufweist.

## Revendications

1. Châssis (10) à refroidissement par jet d'air froid distribué, le châssis comprenant :
une ou plusieurs parois latérales (12) définissant un volume conçu pour essentiellement entourer un ou plusieurs composants générateurs de chaleur positionnés à l'intérieur du volume ;
au moins un réseau d'ailettes (14) accouplées thermiquement à une paroi respective de la ou des parois latérales ;
au moins un ensemble de jets synthétiques (30) comprenant un jet synthétique à orifices multiples (30) ou une pluralité de jets synthétiques à orifice unique (2) disposés sur un côté (15, 16) d'une ailette respective du ou des réseaux d'ailettes ; et
au moins un moyen de fixation (4, 6, 9, 11, 20, 44) pour fixer un ensemble de jets synthétiques respectif du ou des ensembles de jets synthétiques à une paroi latérale respective de la ou des parois latérales ;
les ailettes (14) comprenant des plaques-ailettes (14) agencées dans une configuration de rainures en V dans laquelle :
(i) des lignes centrales des plaques-ailettes (14) sont parallèles à des lignes centrales des jets (2, 30) ;
(ii) des distances (d) entre un jet respectif (2, 30) et une plaque-ailette (14) respective augmentent d'un bord vers un centre du réseau d'ailettes (14) ;
(iii) les jets (2, 30) sont agencés le long d'une ligne perpendiculaire aux lignes centrales des plaques-ailettes (14) ; et
(iv) des longueurs de plaques-ailettes (14) respectives diminuent d'un bord vers un centre du réseau d'ailettes (14).

2. Châssis (10) selon la revendication 1, dans lequel le ou les ensembles à jet synthétique (30) comprennent une pluralité de jets synthétiques à orifice unique (2), dans lequel au moins une des parois latérales (12) comporte une pluralité de fentes (8) disposées sur au moins l'un des côtés (15, 16) du réseau d'ailettes (14), et dans lequel le ou les moyens de fixation sont conçus pour être insérés dans des fentes respectives et pour fixer le jet synthétique à orifice unique à la fente.

3. Châssis (10) selon la revendication 1, dans lequel le ou les ensembles à jet synthétique (30) comprennent une pluralité de jets synthétiques à orifice unique (2), dans lequel le ou les moyens de fixation comprennent une pluralité d'agrafes (4), chacune des agrafes ayant une partie courbée (5), dans lequel chacun des jets synthétiques à orifice unique est fixé à une agrafe respective, et dans lequel la partie pliée de chacune des agrafes est attachée à une paroi latérale respective de la ou des parois latérales (12).

4. Châssis (10) selon la revendication 1, dans lequel le ou les ensembles à jet synthétique (30) comprennent une pluralité de jets synthétiques à orifice unique (2), dans lequel le ou les moyens de fixation comprennent une pluralité de parties flexibles (6), dans lequel chacun des jets synthétiques à orifice unique a au moins une partie flexible fixée à celui-ci, et dans lequel chacune des parties flexibles est attachée à une paroi latérale respective de la ou des parois latérales (12), et dans lequel au moins un des jets synthétiques à orifice unique (2) est orienté selon un angle par rapport aux ailettes (14).

5. Châssis (10) selon la revendication 1, dans lequel le ou les ensembles de jets synthétiques (30) comprennent une pluralité de jets synthétiques à orifice unique (2), dans lequel le moyen de fixation comprend un cadre (9) et une pluralité de tiges (11) fixées au cadre et s'étendant à partir de celui-ci, dans lequel chacun des jets synthétiques à orifice unique est fixé à deux tiges voisines, dans lequel le moyen de fixation comprend en outre une pluralité de parties flexibles (6), dans lequel chacun des jets synthétiques à orifice unique a au moins deux parties flexibles qui y sont fixées, et dans lequel les jets synthétiques à orifice unique sont fixés aux tiges (11) par l'intermédiaire des parties flexibles.

6. Châssis (10) selon la revendication 1, dans lequel le ou les ensembles de jets synthétiques (30) comprennent une pluralité de jets synthétiques à orifice unique (2), dans lequel le moyen de fixation comprend un boîtier partiellement fermé (20), dans lequel chacun des jets synthétiques à orifice unique est disposé à l'intérieur du boîtier partiellement fermé,
dans lequel le boîtier partiellement fermé (20) comprend une première partie (22) et une seconde partie (24), dans lequel la première partie définit une pluralité d'ouvertures (26) conçues pour recevoir des jets synthétiques à orifice unique (2) respectifs, dans lequel la seconde partie est fixée à la première partie pour couvrir les ouvertures,
dans lequel le boîtier partiellement fermé (20) comprend en outre une pluralité de joints d'étanchéité (28), chacun des joints d'étanchéité étant disposé dans une ouverture respective et recevant un jet synthétique à orifice unique (2) respectif, et dans lequel le boîtier partiellement fermé est fixé à une paroi latérale (12) respective.

7. Châssis (10) selon la revendication 1, dans lequel une paroi latérale inférieure (42) des parois latérales (12) n'a pas de réseau d'ailettes, dans lequel le moyen de fixation comprend au moins une plaque (44) montée sur la paroi latérale inférieure, dans lequel au moins l'un des jets synthétiques à orifice unique (2) est monté sur la plaque et orienté pour diriger un jet vers l'extérieur, et dans lequel la plaque a au moins une partie courbée pour guider le jet autour d'un coin du châssis pour une incidence sur le réseau d'ailettes sur une paroi latérale voisine, ou
dans lequel le moyen de fixation comprend une plaque (44) montée sur la paroi latérale inférieure, dans lequel au moins deux des jets synthétiques à orifice unique (2) sont montés sur la plaque et orientés pour diriger les jets respectifs vers l'extérieur dans des directions opposées, et dans lequel la plaque a deux parties courbées pour guider des jets respectifs autour du coin respectif du châssis pour une incidence sur le réseau d'ailettes sur des parois latérales voisines respectives.

8. Châssis (10) selon la revendication 1, dans lequel une paroi latérale inférieure (42) des parois latérales (12) n'a pas un réseau d'ailettes, dans lequel le moyen de fixation comprend au moins une plaque (44) montée sur la paroi latérale inférieure, dans lequel au moins l'un des jets synthétiques à orifice unique (2) est monté sur la plaque et orienté pour diriger un jet vers l'extérieur, et dans lequel la plaque a au moins une partie courbée pour guider le jet autour d'un coin du châssis pour une incidence sur le réseau d'ailettes sur une paroi latérale voisine,
dans lequel le moyen de fixation comprend une première plaque (44a) et une seconde plaque (44b) montées sur la paroi latérale inférieure, dans lequel au moins l'un des jets synthétiques à orifice unique (2) est monté sur la première plaque et orienté pour diriger un jet vers l'extérieur dans une première direction, dans lequel au moins l'un des jets synthétiques à orifice unique est monté sur la seconde plaque et orienté pour diriger un jet vers l'extérieur dans une seconde direction, et dans lequel chacune des première et seconde plaques a une partie courbée pour guider le jet respectif autour du coin respectif du châssis pour une incidence sur le réseau d'ailettes sur la paroi latérale voisine respective des parois latérales.

9. Châssis (10) selon la revendication 1, dans lequel chacun des jets synthétiques à multiples orifices comprend :
une première structure flexible (32) ;
une seconde structure flexible (34) ;
au moins un matériau actif (36) accouplé à au moins l'une des première et seconde structures flexibles ; et
une paroi souple (38) positionnée entre les première et seconde structures flexibles et définissant une chambre, la paroi souple définissant une pluralité d'orifices (39) pour faciliter la communication fluide entre la chambre et un environnement ambiant des ailettes.

10. Châssis selon la revendication 1, dans lequel au moins un sous-ensemble des orifices a une longueur d'ouverture L dans une plage d'environ 8 mm à environ 17 mm.

11. Châssis selon la revendication 2, dans lequel au moins un sous-ensemble des orifices a une longueur d'ouverture L dans une plage d'environ 13 mm à environ 17 mm.
